Europäisches Patentamt

European Patent Office

Office européen des brevets

(19)

(11) **EP 0 954 108 A1**

(12) **DEMANDE DE BREVET EUROPEEN**

(43) Date de publication:
**03.11.1999 Bulletin 1999/44**

(51) Int Cl.⁶: **H03M 13/00**

(21) Numéro de dépôt: **99401017.1**

(22) Date de dépôt: **26.04.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **28.04.1998 FR 9805332**

(71) Demandeur: **ALCATEL**
**75008 Paris (FR)**

(72) Inventeurs:
• **Fang, Juing**
  **92300 Levallois (FR)**
• **Lemaire, Vincent**
  **91120 Palaiseau (FR)**

(74) Mandataire: **Lamoureux, Bernard et al**
**COMPAGNIE FINANCIERE ALCATEL**
**Dépt. Propriété industrielle**
**30, avenue Kléber**
**75116 Paris (FR)**

(54) **Procédé et dispositif de codage correcteur d'erreurs pour des transmissions de données numériques à débit élevé, et procédé et dispositif de décodage correspondant**

(57) Pour réaliser une transmission codée dont le rendement puisse être adapté en fonction des besoins d'un système et d'une application, on propose de réaliser un codage de canal qui comporte plusieurs codeurs et décodeurs concaténés en série et en parallèle. Dans l'invention, les codeurs sont du type CSOC, c'est à dire des codeurs convolutifs orthogonaux. On montre qu'en agissant ainsi, on peut réaliser une adaptation parfaite avec des circuits dont la complexité et le coût sont par ailleurs très faibles et qui de ce fait supportent bien les hauts débits.

Figure. 3

## Description

La présente invention a pour objet un procédé et un dispositif de codage correcteur d'erreurs pour des transmissions de données numériques à débit élevé, notamment par fibre optique à longue distance, ainsi qu'un procédé et un dispositif de décodage correspondant. Dans l'invention, une meilleure résistance au bruit est apportée à la transmission de messages numériques par un système de codage de ces messages numériques. Elle concerne préférentiellement le domaine du codage correcteur d'erreurs dit FEC (Forward Error Correction) sans retour d'information à partir du récepteur, par opposition à la technique de codage dite ARQ (Automatic Repeat reQuest) dans laquelle un accusé de réception est émis par le récepteur. Elle est plus particulièrement utilisable dans les systèmes sous-marins de transmission par fibre optique.

Dans un tel système de transmission à très longue distance et à débit très élevé, de l'ordre du gigabits par seconde, la fonction du codage correcteur d'erreurs FEC est indispensable pour assurer la qualité du service et économiser le nombre des amplificateurs optiques qui sont utilisés comme répéteurs dans la partie submergée du système. De fait, un codage correcteur d'erreurs diminue le coût global du système. Il est possible, à des noeuds de réorganisation d'un tel système, de provoquer en plus une régénération des bits transmis. Mais la complexité des équipements nécessaires pour de telles régénérations, et leur fiabilité malgré tout limitée, rendent leur installation impossible dans des répéteurs submergés.

On connaît ainsi les liaisons transatlantiques TAT12 - TAT13 ou Gemini, la liaison SeaMeWe3 qui longe les côtes de l'Europe et de l'Asie, ou les liaisons transpacifiques Southern Cross ou US/China (certaines de ces liaisons ne sont pas encore opérationnelles).

D'une manière plus générale, dans tous les systèmes de transmission à débit très élevé, le codage FEC a des contraintes spécifiques, en facteur d'expansion de bande, et surtout en vitesse de traitement et en complexité. Il faut donc choisir un codage qui possède à la fois une bonne performance en terme du gain du codage et une faible complexité, de façon à permettre une mise en oeuvre de faible coût et une faible consommation de puissance.

Dans l'invention, on envisage en outre l'utilisation d'un codage concaténé. Un codage concaténé utilise en général deux codages, l'un dit codage intérieur, l'autre extérieur. Le codage intérieur est le traitement qui, dans le système de codage global, précède directement la transmission par le médium physique de transmission, la fibre optique dans l'exemple étudié. Le codage extérieur est celui par lequel des bits d'information à transmettre sont codés avant d'être fournis au circuit de codage intérieur. Le codage concaténé réalise un bon compromis performance/complexité.

L'objectif de la présente invention est de proposer plusieurs constructions et une mise en oeuvre de faible complexité du codage intérieur, notamment dans le cadre d'un système de codage concaténé. De préférence le codage concaténé utilisera alors un codage extérieur de Reed-Solomon (RS). Les codages intérieurs ainsi construits seront néanmoins utilisables seuls, selon les applications envisagées. De même le codage extérieur pourra être un autre codage qu'un codage RS. Il pourra par exemple être un codage CSOC, Codage Convolutif Orthogonal (Convolutional Self-Orthogonal Code). Le but est d'offrir une bonne performance et une faible complexité, s'adaptant bien aux transmissions à débit très élevé, à plusieurs gigabits par seconde, notamment celui des systèmes sous-marins à fibre optique.

Les solutions connues de codage sont les suivantes :

 a) Codage non binaire en blocs de Reed-Solomon ;
 b) Codage binaire en blocs du type Hamming ou BCH ;
 c) Codage concaténé utilisant a) et ou b) pour le codage extérieur et le codage intérieur;
 d) Codage concaténé d'un codage RS et d'un codage convolutif avec décodage de Viterbi à décision souple ;
 e) Codage dit "Turbo".

Ces solutions de codages ne sont pas suffisantes. Les raisons en sont les suivantes.

La solution a) utilise un codage très performant et bénéficie de réalisations existantes de composants circuits intégrés VLSI chez beaucoup de fondeurs, grâce à la popularité des codages RS. On connaît ainsi le codage normalisé dit RS (255,239) capable de corriger 8 erreurs avec seulement 16 octets (255-239) de redondance. Mais ces codages RS fonctionnant en symboles non binaires ne sont pas bien adaptés à une transmission binaire comme c'est le cas dans les transmissions par fibres optiques. A titre d'exemple, pour une longueur de bloc et un rendement fixés, un codage BCH corrige un nombre d'erreurs binaires plus important qu'un codage RS.

La solution b) ne présente pas, théoriquement,- de problème d'adaptation aux transmissions binaires. Toutefois, un codage de Hamming n'est pas assez performant, alors que par ailleurs les codages BCH nécessitent la même complexité que les codages RS. Cependant, l'inconvénient présenté par les codages BCH est que les circuits qui les exécutent ne sont pas disponibles pour des débits très élevés. Or, développer un circuit de codage et de décodage algébrique BCH demande un effort bien plus important que pour un codage RS. En effet, on ne trouve pas de circuits existants pour les codages BCH dans les bibliothèques chez des fondeurs de circuits VLSI alors que ces circuits sont facilement disponibles pour des codages RS. Le travail de conception est donc lourd, la durée de mise au point serait très longue.

La solution c) signifie les systèmes concaténés utilisant un codage extérieur RS et un codage intérieur qui peut être soit un autre codage RS soit un codage BCH. L'un des deux points faibles des solutions a) et b) existe toujours dans ce schéma. De plus, ce schéma ne peut bien fonctionner qu'avec un entrelacement efficace, ce dernier pourrait être très coûteux pour un débit élevé. En effet, le codage intérieur permet de corriger une grande partie des erreurs aléatoires, mais des erreurs résiduelles non corrigées tendent alors à être groupées. De manière à corriger ces erreurs résiduelles groupées, il convient de les distribuer sur plusieurs mots de codage. Ceci est obtenu par un entrelacement au codage et un désentrelacement correspondant au décodage.

La solution d) doit être notamment utilisée en décision souple pour être suffisamment performante, c'est à dire avec un échantillonnage et une quantification du signal reçu sur une dynamique de plusieurs bits. Or, les circuits de mise en oeuvre d'une décision souple présentent encore des difficultés techniques de réalisation, pour des débits de l'ordre du gigabit par seconde. Actuellement, le décodage de Viterbi avec un seul décodeur n'est pas encore réalisable. Par ailleurs, si un décodeur utilisant des décodeurs de Viterbi en parallèle est envisagé, le nombre de ces décodeurs serait de l'ordre de plusieurs centaines, donc trop élevé. Ainsi, le seul circuit accessible aujourd'hui est le circuit ST-2060 de Standford Telecom, USA. Ce circuit supporte un débit de 45Mbits/s. Or, dans le domaine des liaisons optiques, les débits d'information envisagés sont de l'ordre de 10 Gbits/s par canal, et il est prévu de distribuer 32 canaux sur la bande de fréquence utilisée en transmission optique. Ainsi, un nombre trop important (de l'ordre de 600) de décodeurs de Viterbi devrait être réalisé. En outre, les échanges entre les différents décodeurs seraient en euxmêmes excessivement volumineux et complexes.

La solution e) nécessite un décodage par décision souple, en plus du problème de complexité du décodage itératif qui lui est propre. Pour les mêmes raisons que pour la solution d), le codage "Turbo" n'est pas utilisable pour les transmissions à des Gbits par seconde sur fibre optique.

L'invention a pour objet de remédier à ces inconvénients et de proposer une solution industriellement et immédiatement exploitable. L'idée de base de l'invention est d'utiliser pour le codage des circuits de Codages Convolutifs Orthogonaux, CSOC. Dans l'invention, les codages convolutifs orthogonaux sont composés. Les codages de type CSOC sont une classe de codage de haut rendement et de très faible complexité, mais avec des gains de codage faibles et moyens. On montre dans l'invention qu'ils peuvent néanmoins être intéressants dans les applications de transmission sur fibre optique. Ils pourraient tout aussi bien être intéressants dans d'autres applications.

On rappelle que le rendement (K/N) est le rapport du nombre (K) de bits d'information à transmettre sur le nombre (N) de symboles effectivement transmis en correspondance. Le gain d'un codage CSOC dépend essentiellement de deux paramètres J (nombre d'équations orthogonales) et Ne longueur de contrainte effective. Le gain exprime la réduction du rapport signal sur bruit pour laquelle on continue à garantir une performance donnée. Ainsi, plus le nombre de symboles à envoyer est grand, plus l'occupation de la largeur de bande de fréquence attribuée au canal est grande, et plus la redondance est grande.

Dans l'invention, en plus de la complexité faible à rechercher, il convient aussi d'augmenter le gain le plus possible. On montrera qu'avec l'invention le choix des circuits de codage CSOC permet néanmoins de s'adapter très exactement à la largeur disponible de la bande de fréquence du canal de transmission utilisé. Un des objectifs de l'invention est, de ce point de vue, de conduire à une occupation optimale de la bande passante disponible, en choisissant des codages à la demande, mais sans que les circuits de codage à réaliser qui leur correspondent ne soient trop complexes à concevoir et ou à réaliser.

Les codages CSOC ont été largement utilisés dans les transmissions par satellite, grâce à leur simplicité de mise en oeuvre. Bien que leurs gains soient faibles et moyens, ils étaient suffisamment intéressants pour ces applications entre les années 60 et 80, avant l'application de l'algorithme de Viterbi avec décision souple. Ils conviennent bien en fait si le niveau de la technologie électronique est limité alors que, par comparaison, l'algorithme de Viterbi avec décision souple fournit des performances largement meilleures mais seulement si ce niveau de la technologie n'est pas une limitation.

Dans l'invention, on s'est rendu compte qu'on se trouvait, avec les transmissions de signaux optiques sur fibres optiques à grand débit, dans une situation comparable où les débits sont tellement élevés que l'algorithme de Viterbi avec décision souple n'est pas envisageable. Il est apparu utile alors d'utiliser des codages CSOC pour ces systèmes.

Or, un seul codage CSOC a un gain de codage trop modeste. Dans l'invention, comme ils sont tellement simples à implanter, même par une technologie ASIC moyenne, on les combine pour obtenir de meilleures performances.

Une propriété spécifique des codages CSOC est que leurs décodeurs ne produisent pas de paquets d'erreur en sortie lorsqu'ils ont des erreurs d'entrée non corrigibles. Cette propriété est utilisée à titre de perfectionnement comme l'un des éléments constructifs de la présente invention.

L'idée de base de l'invention est de combiner plusieurs circuits de décodage CSOC en de nouveaux schémas du codage correcteur d'erreurs dénommés "CSOC composés", pour obtenir des performances comparables aux schémas en c) ci-dessus, tout en restant de faible complexité. La présente invention propose plusieurs méthodes de construction des codages convolutifs orthogonaux composés, ainsi que leurs schémas de mise en oeuvre. On montrera que ces méthodes permettent la conception aisée, à la demande, à partir de circuits typiques et faciles à réaliser.

Les conceptions et constructions de circuits CSOC composés ont un intérêt pratique car elles permettent de déterminer rapidement des codes convolutifs à rendements très variés comme qm/q(m+1)+1, (qm-1)/q(m+1), et (qm-1)/q(m+1)+1. Dans ces expressions q et m sont entiers positifs. Ces codes CSOC composés ne sont pas optimaux, mais tous permettent des réalisations simples et rapides de codeurs et décodeurs. Du fait de leur simplicité, ces codeurs et décodeurs peuvent fonctionner à des débits très élevés. Bien qu'il ne soit pas théoriquement impossible de construire des codes convolutifs optimaux aux mêmes rendements, la conception et la réalisation de codes convolutifs de grande taille nécessiterait une puissance de calcul énorme, rendant cette tâche trop difficile. De plus, ces codes convolutifs de grande taille ne seraient pas décodés aussi facilement que ceux proposés par l'approche de l'invention.

La présente invention a donc pour objet un procédé de codage correcteur d'erreurs dans lequel on code des trains de bits à coder avec un circuit de codage convolutif orthogonal, caractérisé en ce qu'il comporte

- une mise en sous-blocs des bits de ces trains de bits à coder,
- des codages convolutifs orthogonaux, en parallèle, des bits de ces sous-blocs de bits, pour produire en parallèle des sous-symboles,
- ces codages convolutifs orthogonaux ayant un rendement du type m/m+1 où m représente le nombre des bits d'un sous-bloc de bits, et
- une concaténation des sous-symboles.

La concaténation peut être une simple juxtaposition, dans le temps et/ou dans l'espace des sous-symboles codés. Ensuite, le cas échéant, on transmet ces sous-symboles concaténés. Ils sont décodés en correspondance à la réception. Le décodage présente la particularité d'être effectué par étapes.

L'invention a encore pour objet un dispositif de codage dans lequel on code des trains de bits à coder avec un circuit de codage convolutif orthogonal, caractérisé en ce qu'il comporte

- un multiplexeur pour mettre en sous-blocs des bits de ces trains de bits à coder,
- des circuits de codage convolutif orthogonaux, en parallèle, pour coder des bits de ces sous-blocs de bits, et pour produire en parallèle des sous-symboles,
- ces circuits de codages convolutifs orthogonaux étant du type avec un rendement m/m+1 où m représente le nombre des bits d'un sous-bloc de bits, et
- un circuit de concaténation pour concaténer les sous-symboles.

Le circuit de codage est normalement relié à un circuit de transmission de ces blocs de sous-symboles. En réception, un circuit de décodage effectue une transformation inverse.

L'invention sera mieux comprise à lecture de la description qui suit et à l'examen des figures qui l'accompagnent. Celles-ci ne sont données qu'à titre indicatif et nullement limitatif de l'invention. Les figures montrent:

Figure 1 : la représentation d'un circuit de codage convolutif orthogonal utilisé dans l'invention avec un rendement du type m/m+1 ;
Figure 2 : un circuit de décodage associé au circuit de codage de la figure 1 pour en montrer la simplicité, et comportant, de préférence, un perfectionnement de contre-réaction ;
Figures 3 à 5 : des exemples de réalisation de circuits de codage et de décodage selon l'invention.

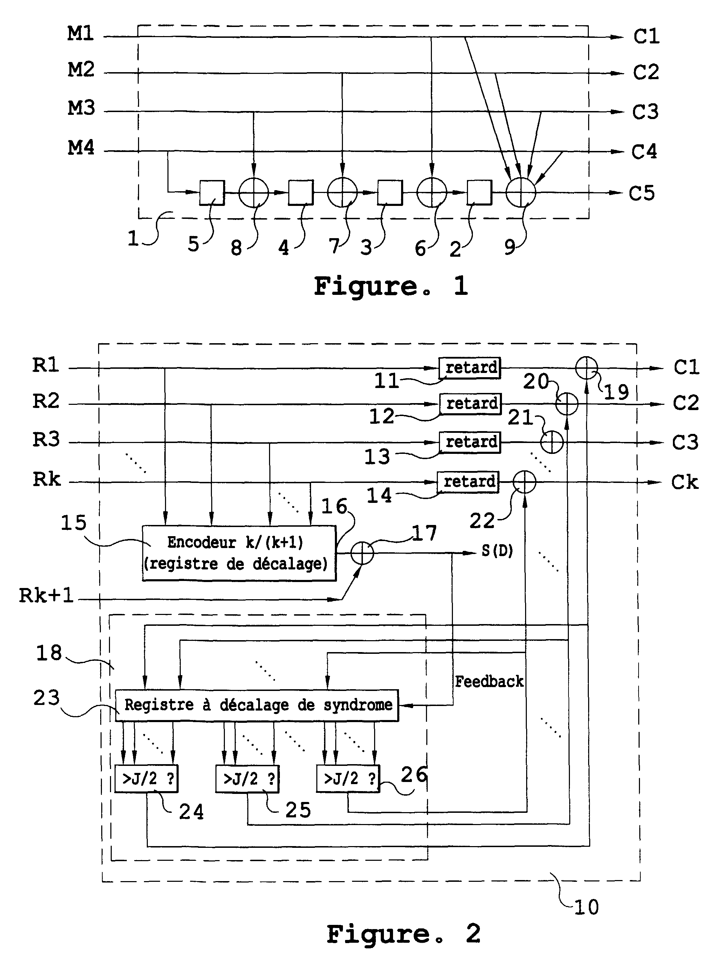

La figure 1 montre un exemple d'un circuit 1 de codage convolutif orthogonal utilisé dans l'invention avec un rendement du type m/m+1. Dans l'invention, quand on présentera des circuits il s'agira préférentiellement de circuits réalisés sous une forme câblée, car cette forme est plus propice à la réalisation sous la forme de circuits intégrés et à la satisfaction des impératifs de vitesse de traitement envisagés. Néanmoins, il serait tout aussi envisageable de réaliser les fonctions de ces circuits au moyen de circuits comportant des microprocesseurs très rapides, leur conférant de plus une certaine programmabilité. Dans l'exemple représenté, le circuit 1 comporte ainsi 4 entrées pour recevoir des signaux binaires M1 à M4. Le circuit 1 produit 5 signaux de sortie notés C1 à C5. Dans la pratique, le nombre de signaux d'entrée peut être plus élevé. Les signaux C1 à C4 sont identiques aux signaux d'entrée M1 à M4. Par contre, le signal C5 est produit par combinaisons des signaux M1 à M4 et de signaux délivrés par des circuits de retard 2, 3, 4 et 5 appliqués aux signaux respectivement M1 à M4. Ces retards sont appliqués par des additionneurs interposés 6 à 8 aux signaux M1 à M4 respectivement, en commun avec un signal provenant d'un circuit de retard précédent, respectivement 3, 4 et 5. Le signal C5 est obtenu en additionnant dans un dernier additionneur 9 le signal produit par le circuit de retard 2 et chacun des signaux M1 à M4. Le circuit de la figure 1 est uniquement binaire, les signaux M1 à M4 et C1 à C5 étant binaires, c'est à dire codés sur un bit.

Le codage proposé par le circuit de la figure 1 est un codage convolutif puisqu'il fait intervenir dans l'élaboration du signal C5 les 4 signaux M1 à M4 présents, ainsi que le signal M1 du bloc de bits précédent, le signal M2 du bloc de bits encore antérieur et ainsi de suite pour les signaux M3 et M4. Le circuit de codage 1 a un rendement R de 4/5, un nombre J de jeux de vérifications orthogonales égal à 2 et une longueur de contrainte Na égale à 25. Dans ces expressions, J a un rôle de mesure de la distance minimale. Plus J est grand, mieux le codage permet de corriger les erreurs dans les bits transmis. En pratique, on corrige un nombre de bits transmis égal à la moitié de la valeur de J. Il y a deux longueurs de contrainte. La longueur de contrainte Na est définie comme le nombre total de bits impliqués dans l'opération de codage. En pratique, le nombre Na est équivalent au nombre de portes logiques que doit comporter le circuit. La longueur de contrainte effective Ne est le nombre de bits d'erreur différents qui apparaissent dans J équations orthogonales. Un code CSOC est d'autant plus puissant que Ne est petit pour un J fixé. Na n'a pas un impact direct et explicite sur la capacité d'un code CSOC. La description est faite ici en référence au circuit 1 de la figure 1 où (R, J, Na) sont équivalents à (4/5, 2, 25). Dans la pratique, on pourra utiliser un codage du type (8/9, 7, 3519) ou (9/10, 7, 4860) ou encore (16/17, 6, 11594). D'autres codes seront vus par la suite.

Tous les codes convolutifs orthogonaux présentés sont du type avec un rendement m/m+1. Le rendement de ces codes est élevé. Un bon code CSOC doit avoir une grande valeur de J et une petite valeur de Ne.

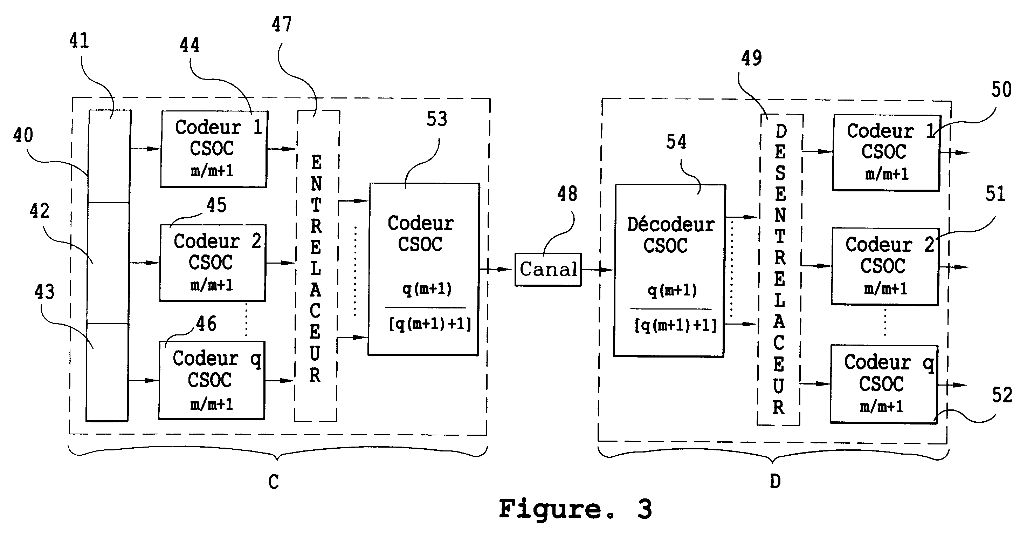

La figure 2 montre un circuit 10 de décodage CSOC. Ce circuit de décodage peut être associé, pour k=4, au circuit de codage de la figure 1. Ce circuit 10 de décodage reçoit k+1 symboles R1 à Rk+1 et produit k signaux utiles M1 à Mk. Le décodeur 10 comporte également des circuits de retard 11 à 14 aménagés dans chaque voie de transmission des signaux R1 à Rk. Les retards sont identiques de manière à produire, pour un bloc de signaux R1 à Rk+1 reçus, un bloc des signaux M1 à Mk correspondants. Ces retards ont une durée de k fois le temps de bit des signaux Ri reçus (ou Mi émis). Un encodeur 15 permet en outre d'effectuer un traitement sur les signaux R1 à Rk analogue au traitement effectué par le codeur 1 de la figure 1 sur M1 à Mk signaux (M4, avec k=4 en généralisant le codeur de la figure 1). L'encodeur 15 produit un symbole convolué à sa sortie 16. Le symbole convolué de la sortie 16 est additionné, modulo 2 dans un additionneur 17 à un bit, au symbole reçu Rk+1 (fonctionnellement, une fonction OU-EXCLUSIF est appliquée au symbole convolué de la sortie 16 et au symbole Rk+1).

En s'en tenant à cette construction, le signal disponible à la sortie de l'encodeur 15, est égal (si la transmission s'est faite sans détérioration) au signal Ck+1 (C5) produit par l'additionneur 9. Dans ce cas, la sortie de l'additionneur 17 est égale à zéro. Par contre, si l'un quelconque des signaux R1 à Rk+1 reçus n'est pas identique au signal correspondant C1 à Ck+1 émis, le signal produit sur la sortie de l'additionneur 17 est un signal indicateur d'erreur qui vaut un. Le signal qui sort de l'additionneur 17 est un signal dit de syndrome S(D). Dans la pratique, le signal S(D) est introduit dans un circuit 18 de correction d'erreurs. Le circuit 18 possède une entrée, celle qui reçoit le signal de syndrome S(D) en provenance de l'additionneur 17, et k sorties. Les k sorties sont reliées à des additionneurs à un bit 19 à 22 pour corriger, en fonction de la valeur du signal de syndrome, par une addition, les signaux R1 à Rk reçus et produire les vrais signaux M1 à Mk correspondant.

Pour simplifier, s'il n'y a pas d'erreur, le signal de syndrome vaut zéro et les k sorties du circuit 18 produisent des signaux zéro qui ne modifient pas dans les additionneurs 19 et 22 les signaux R1 à Rk délivrés. Par contre, si une erreur s'est produite, le signal de syndrome S(D) provoque l'édition d'un signal de correction correspondant. En pratique, le circuit 18 comporte un jeu de circuits de retard réalisés sous la forme d'un registre à décalage 23 cadencé par une horloge à la fréquence bloc de bits. Les cellules de ce registre à décalage de syndrome reçoivent en cascade le signal de syndrome. Le registre 23 forme J signaux pour k comparateurs à seuils 24 à 26. Les k comparateurs 24 à 26 comparent la somme des J signaux à J/2. Dans le cas où ce seuil est dépassé, une erreur est détectée et un signal correspondant admis sur l'additionneur correspondant 19 à 21 corrige l'erreur.

Selon un perfectionnement, dit de contre-réaction, les signaux sortant du circuit 18 sont réintroduits et injectés dans la cascade des cellules du registre à décalage. L'intérêt du circuit de contre-réaction est de provoquer la disparition de la propagation des erreurs. En effet, chaque fois qu'une erreur est détectée et corrigée, elle est réintroduite par la contre-réaction dans les signaux de syndromes correspondant. Ceci permet d'enlever l'influence de cette erreur sur les signaux suivants. Si bien que la propagation d'erreur est réduite, voire supprimée. Le principe de ce décodage à seuil est par ailleurs bien connu.

La figure 3 montre, selon l'invention, un exemple de réalisation de circuit de codage C et de décodage D. Le circuit de codage C comporte une mise en sous-blocs, en parallèle, de trains de bits à transmettre. Ainsi, un train de qm bits à transmettre sera réparti en q sous-blocs de m bits. On peut utiliser pour effectuer cette mise en bloc ou en sous-bloc, n'importe quel type de multiplexeur 40. Il suffit simplement que ce multiplexeur puisse travailler à haut débit. De tels circuits existent couramment car leur fonction est simple. Des sous-blocs de bits 41 à 43 sont alors introduits dans des circuits de codages convolutifs orthogonaux CSOC respectivement 44 à 46. Les circuits 44 à 46 sont ainsi composés, selon l'invention, en parallèle. Les circuits 44 à 46 sont du type de celui de la figure 1. Dans l'exemple préféré, se sont des codeurs à rendement m/(m+1). Ils traitent m bits et produisent m+1 symboles. Tous les symboles produits par les codeurs 44 à 46 sont démultiplexés dans un démultiplexeur 47 avant d'être transmis dans le canal 48 : la fibre optique dans l'exemple étudié. Les codeurs 44 à 46 sont de préférence identiques. Le démultiplexeur 47 joue au moins le rôle d'un circuit de concaténation pour servir d'interface avec le canal 48

En réception, un multiplexeur 49 reçoit les symboles transmis et les fournit à q décodeurs 50 à 52 correspondant respectivement aux q codeurs 44 à 46 et constitués conformément au circuit de décodage de la figure 2. Comptetenu du nombre plus important de bits traités en parallèle dans les sous-blocs, les circuits 44 à 46 sont légèrement plus complexes que celui de la figure 1. Néanmoins, ils sont très simples.

En particulier les additionneurs et les circuits de retard de tous ces circuits peuvent être réalisés sous la forme de circuit à décalage. Ceci autorise les débits évoqués précédemment de 10 Gbits par seconde. Actuellement, les portes électroniques disponibles sont capables de fonctionner à ces vitesses.

Le démultiplexeur 47 peut par ailleurs être un entrelaceur dont les sorties sont reliées à un autre codeur 53 du type CSOC lui aussi. Recevant q fois m+1 sous-symboles, le codeur 53, qui est du même type que les codeurs 44 à 46, produira q(m+1)+1 symboles. En pratique, le circuit C global avec les q codeurs 44 à 46, l'entrelaceur 47 et le codeur 53, effectue un codage avec un rendement qm/(q(m+1)+1). A la réception, un décodeur 54 du même type que le décodeur de la figure 2 mais correspondant au codeur 53, fournit q(m+1) sous-symboles pour q(m+1)+1 symboles reçus. Les q(m+1) sous-symboles sont injectés dans le multiplexeur 49 qui joue alors de préférence le rôle de désentrelaceur.

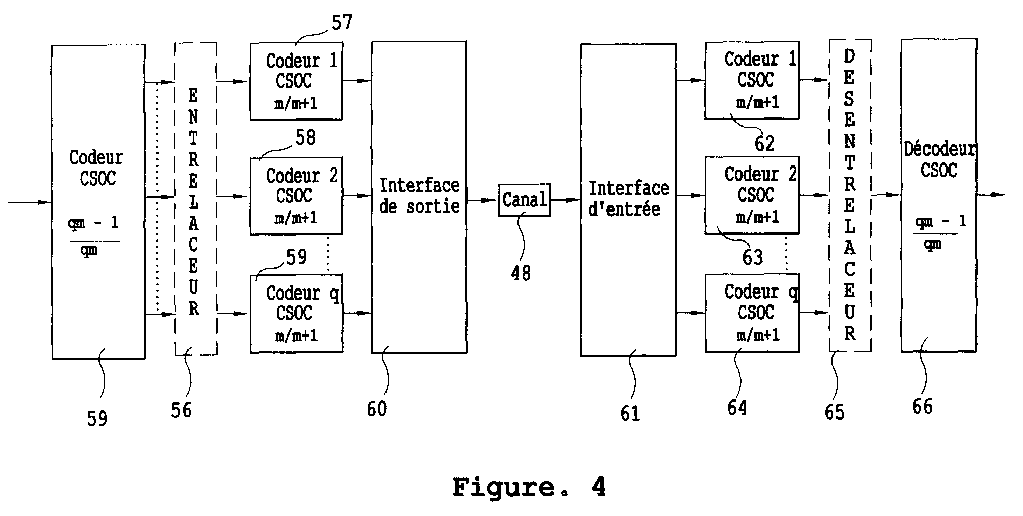

Alors que la figure 3 montrait un montage de q codeurs en parallèle 44 à 46 suivis par un codeur CSOC 53, la figure 4 montre un fonctionnement différent. Dans celle-ci, un codeur CSOC 55 reçoit des trains de qm-1 bits qu'il transforme après traitement en des blocs de qm bits. Ces qm bits sont introduits dans un entrelaceur multiplexeur 56. L'entrelaceur 56 joue à la fois le rôle d'un entrelaceur pour entrelacer les qm bits produits par le codeur 55 et un rôle de multiplexeur, comme le multiplexeur 40, pour alimenter les codeurs CSOC composés. L'entrelaceur 56 est ainsi en relation avec q codeurs CSOC 57 à 59 de rendement m/m+1. Les q codeurs 57 à 59 reçoivent donc q blocs de m bits (formant qm bits) qu'ils convertissent en q(m+1) symboles. Les q(m+1) symboles sont injectés dans un canal de transmission 48 via une interface de sortie 60. En réception, une interface d'entrée 61 sert de multiplexeur et alimente q décodeurs CSOC 62 à 64 qui sont du type inverse aux codeurs 57 à 59. Des sorties des décodeurs 62 à 64 sont introduites dans un multiplexeur 65 jouant de préférence un rôle de désentrelaceur si le multiplexeur 56 a joué un rôle d'entrelaceur. Le multiplexeur 65 alimente alors un décodeur CSOC 66 réciproque du codeur 55. Le décodeur 66 produit alors les trains de qm-1 bits envoyés et reçus. Dans ce cas, les codeur 55 et décodeur 66 jouent le rôle de circuits de codage extérieur. En variante, ces circuits 55 et 66 peuvent être remplacés par des circuits de type Reed-Solomon.

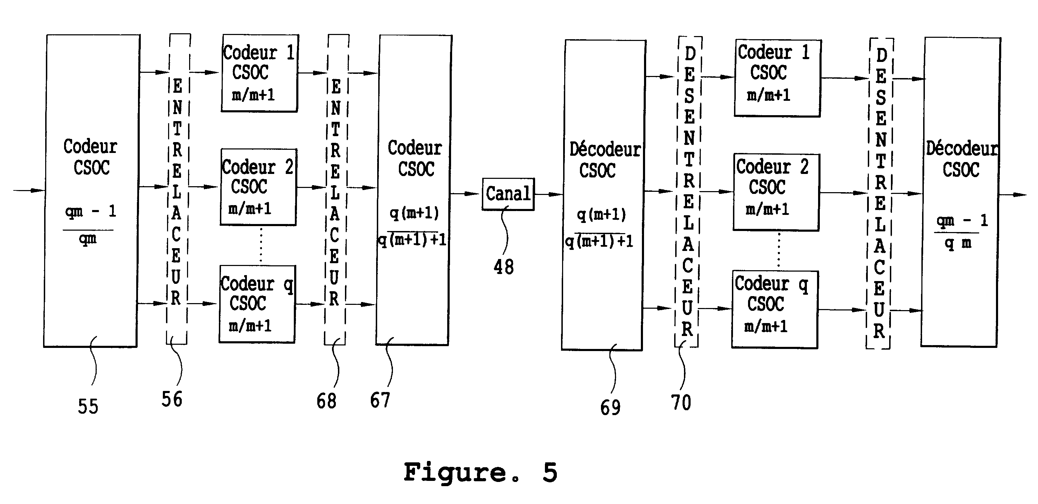

La figure 5 montre une organisation encore plus complexe dans laquelle l'assemblage en parallèle des circuits de codage CSOC est comprise entre un codeur CSOC 55 identique à celui de la figure 4 et un codeur CSOC 67 à rendement q(m+1)/(q(m+1)+1). Dans ce cas, un deuxième entrelaceur 68 est interposé entre le groupe en parallèle des codeurs 57 à 59 et le codeur 65. En réception, un décodeur 69 du type CSOC correspond au codeur 67, un désentrelaceur 70 correspondant à l'entrelaceur 68. Le reste du schéma est identique à celui de la figure 4.

Comme on peut le constater, dans tous les cas les codeurs CSOC sont du type dont le rendement est m/m+1, ils sont élevés. Ces codeurs présentent une très grande simplicité de conception : cf. figure 1. Par contre, leur assemblage en parallèle permet d'obtenir des rendements globaux très variés. Aussi, compte tenu de l'occupation en fréquence d'un spectre de signal à transmettre, on pourra adapter le rendement aussi finement qu'on le désire pour occuper au mieux la bande disponible. Comme on peut le constater, la complexité des circuits impliqués est très faible et supporte donc des débits très élevés. Il est possible d'effectuer autant d'arrangements série-parallèle-série ou paralléle-série-parallèle que nécessaire en vue d'adapter le rendement aux besoins.

Les arrangements des figures 3 à 5 fournissent des performances différentes de celles des codages composants utilisés dans leurs constructions. En effet, les codeurs CSOC composés de la présente invention sont des codages convolutifs plus complexes, mais ils présentent l'avantage de pouvoir être décodés, étape par étape, par des décodeurs à logique majoritaire, de préférence avec contre-réaction, de faible complexité. Bien que les codages CSOC composés ne soient plus forcément des codages CSOC, ils peuvent être décodés par des décodeurs à seuil à contre-réaction qui sont simples et donc rapides. Il peut être démontré que les codages CSOC composés, construits par les méthodes de l'invention, sont des codages convolutifs systématiques. Ceci est illustré par les développements mathématiques suivants.

En effet, en ce qui concerne deux circuits $C_1$ et $C_2$ quelconques, de type CSOC, en cascade, on peut effectuer les développements suivants :

Notons $G_1(D)$ la matrice génératrice du codage du circuit $C_1$, sous la forme systématique

$$G_1(D) = [I_m | g],$$

où $I_m$ est la matrice d'unité de rang m,
et où $\underline{g} = [g_1(D), g_2(D), ..., g_m(D)]$.

De même pour le codage du circuit $C_2$,

$$G_2(D) = [I_{m+1} | \underline{g}],$$

où $I_{m+1}$ est la matrice d'unité de rang m+1,
et OÙ $\underline{g} = [q_1(D), q_2(D), ..., q_{m+1}(D)]$.

Alors, ces deux codages en cascade sont équivalent à un seul codage de rendement m/m+2, avec sa matrice génératrice donnée par

$$G(D) = G_1(D)^* G_2(D) = [G_1 | G_1^* \underline{g}] = [I_m | \underline{g} | \underline{r}],$$

où

$$\underline{r} = [q_1(D) + g_1(D)^* q_{m+1}(D), q_2(D) + g_2(D)^* q_{m+1}(D), ..., q_m(D) + g_m(D)^* q_{m+1}(D)].$$

Bien qu'il soit discuté que le codage composé soit encore un codage de type CSOC, le code produit par ce codage composé peut être décodé par deux décodeurs à logique majoritaire avec contre-réaction de type CSOC montés en cascade. Les deux décodeurs sont du type m+2/m+1 et m+1/m respectivement. De manière optionnelle, un entrelacement peut être prévu entre les deux décodeurs. Ce type de décodage est plus avantageux qu'un seul décodeur m+2/m qui théoriquement existe, mais qui est très complexe à concevoir et à réaliser. On notera toutefois qu'une cascade impose que les sous-symboles délivrés par un circuit soient les bits du circuit suivant.

En ce qui concerne des circuits $C_1$ et $C_2$ de type CSOC en parallèle, on peut effectuer les développements suivants :

Notons la matrice génératrice du codage du circuit $C_1$, $G_1(D)$, sous la forme systématique

$$G_1(D) = [I_m | \underline{g}],$$

où $I_m$ est la matrice d'unité de rang m,
et où $\underline{g} = [g_1(D), g_2(D), ..., g_m(D)]$.

De même pour le codage $C_2$,

$$G_2(D) = [I_n | \underline{g}],$$

où $I_n$ est la matrice d'unité de rang n,
et où $\underline{g} = [q_1(D), q_2(D), ..., q_n(D)]$.

Alors, ces deux codes en cascade sont équivalent à un seul code C de rendement m+n/m+n+2, avec sa matrice génératrice donnée par

$$G(D) = \left[ I_{m+n} \left| \begin{array}{c|c} \underline{g} & 0 \\ \hline 0 & \underline{q} \end{array} \right. \right]$$

Ce code est lui aussi décodé par deux décodeurs à logique majoritaire avec contre-réaction en parallèle. Mais dans ce cas, la présence de m et n permet de modifier le rendement à la demande, soit en différenciant m de n, soit en mettant plus ou moins de circuits CSOC en parallèle, soit les deux en même temps.

Dans le circuit C, figure 3, les circuits de codages CSOC 44 à 46 peuvent ainsi être de rendements identiques ou différents. Quand ils sont différents, le schéma du codage composé offre la capacité d'une protection inégale (UEP : Unequal Error Protection), propriété recherchée par beaucoup d'applications de transmission et de stockage dans le domaine du multimédia.

Pour fonctionner dans les systèmes de transmission par fibre optique, les signaux électriques sont traités largement en parallèle pour s'adapter à la grande vitesse dans la fibre optique. Dans la mise en oeuvre des circuits CSOC composés, l'invention propose des codeurs/décodeurs en parallèle avec une horloge unique. Si toutes les entrées et sorties sont en parallèle, la vitesse maximale est atteinte avec une horloge unique. Dans cette mise en oeuvre, avec un coup d'horloge, le codeur sort en parallèle tous les symboles binaires codés. En conséquence, le décodeur sort tous les bits décodés en parallèle. De ce fait, les circuits de codage CSOC composés, et les circuits de décodage CSOC composés peuvent être implantés en une architecture du type systolique, particulièrement intéressante pour des applications de transmissions à débit élevé. Les codeurs et décodeurs sont implantés en parallèle, avec une horloge unique dans toutes les constructions citées ci-dessus.

Un multiplexage et un démultiplexage sont utilisables dans les applications où un des schémas CSOC composés est employé, non seulement pour obtenir un gain de codage, mais encore pour ajuster les débits différents présents aux interfaces. Dans ces cas, un changement de cadence d'horloge doit être effectué. Cette option permet d'avoir une souplesse nécessaire dans l'insertion d'un codeur décodeur (codec) CSOC composé dans un équipement terminal d'un système de transmission par fibre optique.

Les codages CSOC composés sont utilisables soit en tant que codage intérieur des systèmes de codage concaténé, soit en tant que le seul codage, dans des systèmes de transmission et de stockage qui nécessitent une faible complexité mais un débit élevé.

Les décodeurs CSOC sont à logique majoritaire avec contre-réaction. Grâce à cette contre-réaction, ils ne produisent pas de paquets d'erreur en sortie. Cependant, des erreurs non corrigées passent sans être touchées à la sortie. Pour que ces erreurs soient traitées par les décodeurs suivants, des entrelaceurs sont proposés en option dans les figures 3 à 5.

Les codages CSOC peuvent aussi être décodés en décision souple par des algorithmes de décodage symbole par symbole, par exemple, l'algorithme "APP" (A Posteriori Probability) et ses versions simplifiées, tel que décrit par exemple décrit dans l'article "New convolutional codes - Part II", IEEE Transaction on Communications, vol. COM-23, n° 9, Jan. 76. Il y est indiqué que les codages par des circuits CSOC composés en cascade sont décodés par ce type d'algorithme qui est appliqué à chaque codage composant.

Bien que les constructions par combinaisons des codages CSOC composants s'appliquent aux autres codages composants, par exemple, des codages binaires ou non binaires en blocs, on préfère les codages CSOC car ces codages ont une propriété particulière. En effet, les décodeurs à logique majoritaire avec contre-réaction des codages CSOC ne produisent pas de paquets d'erreurs en sortie des décodeurs lorsque des erreurs sont présentes à leur entrée qui ne dépassent pas leur capacité de correction. Cette propriété garantit que les erreurs ne sont pas propagées, dans un décodeur à logique majoritaire avec contre-réaction de codage CSOC composé, d'un étage à un autre. A travers un décodeur à logique majoritaire avec contre-réaction, le nombre d'erreurs est toujours diminué.

Les figures 3-5 montrent quelques exemples des codages CSOC composés. Beaucoup d'autres sont possibles. L'entrelacement encadré en ligne pointillé est en option dans tous ces schémas.

La figure 3 montre un exemple de construction à partir de q circuits de codage CSOC de type m/(m+1), identiques en parallèle, dont les sous-symboles produits sont ensuite concaténés dans un seul circuit CSOC de type qm/(q(m+1)+1). Par exemple, si m=8 et q=3, le codage est au global un codage 24/28 = 6/7, donc un nouveau codage. Le codage composé est néanmoins plus performant que tous ses codages composants.

La figure 4 montre une autre construction à partir d'un premier circuit de codage CSOC (qm-1)/qm composé en cascade avec q circuits de codage CSOC m/m+1 identiques et en parallèle. Globalement, le codage est un codage de type (qm-1)/q(m+1). Par exemple, si m=8 et q=4, un nouveau codage avec un rendement de 28/36=7/9. Le codage composé est plus performant que tous ses codages composants.

La figure 5 montre encore une autre construction série-parallèle-série à partir d'un premier circuit CSOC (qm-1)/qm composé en cascade avec q circuits CSOC m/m+1 identiques et en parallèle, dont les sous-symboles produits sont ensuite concaténés dans un circuit CSOC de type q(m+1)/(q(m+1)+1). Globalement, le codage est du type (qm-1)/(q(m+1)+1). Par exemple, si m=6 et q=4, un nouveau codage 23/29 est ainsi créé. Le codage composé est plus performant que tous ses codages composants.

Les avantages de la solution de l'invention sont les suivants : complexité faible, rendements variables disponibles, bonnes performances, capacité d'offrir une protection d'erreurs inégale, et mise en oeuvre à débits élevés avec une seule horloge, du type systolique.

En outre, le parallélisme dans des compositions des codages CSOC présente certains avantages par rapport à une concaténation en cascade dans la construction du codage CSOC composé. Un parallélisme permet en effet de construire un codage CSOC composé sans trop augmenter la longueur de contrainte globale, en évitant de mettre un nombre trop important de codes CSOC en cascade.

Les codages CSOC sont décodables en décision souple par la famille d'algorithmes APP. On peut appliquer l'algorithme APP même en décision ferme avec contre-réaction et on obtient une meilleure performance. Dans l'invention, comme il s'agit d'un décodeur composé de plusieurs décodeurs simples en parallèle et en série, il est possible de décoder les codes des composants par l'algorithme APP en décision souple dès le deuxième niveau. En appliquant un algorithme APP, avec ou sans contre-réaction (i.e. feedback), chaque décodeur devient un décodeur à entrée souple et sortie souple dit SISO (Soft-Input-Soft-Output), permettant un décodage itératif appelé décodage Turbo, améliorant largement la performance du schéma CSOC composé.

## Revendications

1. Procédé de codage correcteur d'erreur dans lequel on code des trains de bits à coder avec un circuit (1) de codage convolutif orthogonal, caractérisé en ce qu'il comporte

   - une mise (40) en sous-blocs (41-43) des bits de ces trains de bits à coder,
   - des codages (44-46) convolutifs orthogonaux, en parallèle, des bits de ces sous-blocs de bits, pour produire en parallèle des sous-symboles,
   - ces codages convolutifs orthogonaux ayant un rendement du type $m/m+1$ où $m$ représente le nombre des bits d'un sous-bloc de bits, et
   - une concaténation des sous-symboles.

2. Procédé selon la revendication 1, caractérisé en ce que la concaténation comporte une transformation des sous-symboles en parallèle sous une forme concaténée (47, 53) codée.

3. Procédé selon l'une des revendications 1 à 2, caractérisé en ce que la concaténation comporte un entrelacement (47) des sous-symboles en parallèle.

4. Procédé selon l'une des revendications 1 à 3, caractérisé en ce que la concaténation comporte aussi un codage (53) convolutif orthogonal.

5. Procédé selon l'une des revendications 1 à 4, caractérisé en ce que la mise en sous-blocs comporte un codage extérieur de Reed-Solomon, de préférence de type RS 239-255.

6. Procédé selon l'une des revendications 1 à 5, caractérisé en ce que les sous-blocs de bits sont de taille identique.

7. Procédé selon l'une des revendications 1 à 6, caractérisé en ce que les codages convolutifs orthogonaux sont du type 8/9, 7, 3519 (R, J, Na), du type 9/10, 7, 4860, ou du type 16/17, 6, 11594.

8. Procédé selon l'une des revendications 1 à 7, caractérisé en ce que on met en sous-blocs les bits des trains de bits à coder par une succession en cascade d'un codage (55) de type CSOC et d'un entrelacement (56) de multiplexage.

9. Procédé selon la revendication 8, caractérisé en ce que

   - on entrelace (68) les blocs de sous-symboles produits par les codages de type CSOC composé, et
   - on code les sous-symboles entrelacés par un codage (67) de type CSOC.

10. Procédé de décodage d'un train de bits codé au moyen du procédé de codage selon l'une des revendications 1 à 9, caractérisé en ce que on décode les codages convolutifs orthogonaux par des décodeurs (10) à logique majoritaire.

11. Procédé selon la revendication 10, caractérisé en ce que les décodeurs majoritaires sont à contre réaction (35).

12. Procédé selon l'une des revendications 10 à 11, caractérisé en ce que on décode les codages convolutifs orthogonaux par des décodeurs de type APP, notamment des décodeurs de type APP itératifs Turbo.

13. Procédé selon l'une des revendications 10 à 12, caractérisé en ce que on décode par étapes les codages convolutifs orthogonaux.

**14.** Dispositif de codage dans lequel on code des trains de bits à coder avec un circuit de codage convolutif orthogonal, caractérisé en ce qu'il comporte

- un multiplexeur (40) pour mettre en sous-blocs (41-43) des bits de ces trains de bits à coder,
- des circuits (44-46) de codage convolutif orthogonaux, en parallèle, pour coder des bits de ces sous-blocs de bits, et pour produire en parallèle des sous-symboles,
- ces circuits de codages convolutifs orthogonaux étant d type avec un rendement m/m+1 où m représente le nombre des bits d'un sous-bloc de bits, et
- un circuit de concaténation pour concaténer les sous-symboles.

**15.** Dispositif selon la revendication 14, caractérisé en ce qu'il comporte dans le multiplexeur un circuit de codage (55) de type CSOC et entrelaceur (56).

**16.** Dispositif selon l'une des revendications 14 ou 15, caractérisé en ce qu'il comporte un entrelaceur (47) les blocs de sous-symboles produits par les codages de type CSOC composé.

**17.** Dispositif selon l'une des revendications 14 à 16, caractérisé en ce qu'il comporte un circuit (53) de codage de type CSOC des sous-symboles.

**18.** Dispositif de décodage pour la mise en oeuvre du procédé selon la revendication 10, caractérisé en ce qu'il comprend des décodeurs (10) à logique majoritaire pour le décodage des codes convolutifs orthogonaux.

**19.** Dispositif selon la revendication 18, caractérisé en ce que lesdits décodeurs à logique majoritaire sont à contre-réaction.

**20.** Dispositif selon l'une des revendications 18 ou 19, caractérisé en ce que lesdits décodeurs sont de type APP, notamment de type APP itératifs Turbo.

**21.** Dispositif selon l'une des revendications 18 à 20, caractérisé en ce qu'il comprend différents étages de décodeurs des codes convolutifs orthogonaux.

Figure. 1

Figure. 2

Figure. 3

EP 0 954 108 A1

Codeur CSOC

$\dfrac{qm-1}{qm}$

59

ENTRELACEUR

56

57

Codeur 1 CSOC m/m+1

58

Codeur 2 CSOC m/m+1

59

Codeur q CSOC m/m+1

Interface de sortie

60

Canal

48

Interface d'entrée

61

Codeur 1 CSOC m/m+1

62

Codeur 2 CSOC m/m+1

63

Codeur q CSOC m/m+1

64

DESENTRELACEUR

65

Décodeur CSOC

$\dfrac{qm-1}{qm}$

66

**Figure. 4**

Codeur CSOC

$$\frac{qm - 1}{qm}$$

ENTRELACEUR

Codeur 1 CSOC m/m+1

Codeur 2 CSOC m/m+1

Codeur q CSOC m/m+1

ENTRELACEUR

Codeur CSOC

q(m+1)

q(m+1)+1

Canal

48

Décodeur CSOC

q(m+1)

$\overline{q(m+1)+1}$

DESENTRELACEUR

Codeur 1 CSOC m/m+1

Codeur 2 CSOC m/m+1

Codeur q CSOC m/m+1

DESENTRELACEUR

Décodeur CSOC

$$\frac{qm - 1}{q\,m}$$

55    56    68    67    69    70

Figure. 5

EP 0 954 108 A1

**Office européen des brevets**

**RAPPORT DE RECHERCHE EUROPEENNE**

Numéro de la demande
EP 99 40 1017

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | MARTIN: "Optimal convolutional self-orthogonal codes with an application to digital radio" IEEE INTERNATIONAL CONFERENCE ON COMMUNICATIONS '85, 23 - 26 juin 1985, pages 1249-1253, XP002086300 Chicago, Illinois, USA * le document en entier * | 1,14,18 | H03M13/00 |
| A | D. HACCOUN ET AL.: "New architectures for fast convolutional encoders and threshold decoders" IEEE JOURNAL ON SELECTED AREAS IN COMMUNICATIONS, vol. 6, no. 3, avril 1988 (1988-04), pages 547-557, XP002086302 NY, USA * alinéa 'II.A! - alinéa 'II.B!; figures 2,4 * * alinéa 'IV.A! - alinéa 'IV.C!; figures 8,11 * | 1,14,18 | |
| A | FAZEL K: "INTERATIVE DECODING OF GENERALIZED CONCATENATED BLOKH-ZYABLOV-CODES" 1996 IEEE INTERNATIONAL CONFERENCE ON COMMUNICATIONS (ICC), CONVERGING TECHNOLOGIES FOR TOMORROW'S APPLICATIONS DALLAS, JUNE 23 - 27, 1996, vol. 1, 23 juin 1996 (1996-06-23), pages 96-101, XP000625649 INSTITUTE OF ELECTRICAL & ELECTRONICS ENGINEERS paragraphes 1, 2.1 * figure 2 * -/-- | 1,14,18 | **DOMAINES TECHNIQUES RECHERCHES (Int.Cl.6)** H03M |

Le présent rapport a été établi pour toutes les revendications

| Lieu de la recherche | Date d'achèvement de la recherche | Examinateur |
|---|---|---|
| LA HAYE | 20 juillet 1999 | Augarde, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**EP 0 954 108 A1**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | BENEDETTO S ET AL: "PERFORMANCE EVALUATION OF PARALLEL CONCATENATED CODES" COMMUNICATIONS - GATEWAY TO GLOBALIZATION. PROCEEDINGS OF THE CONFERENCE ON COMMUNICATIONS, SEATTLE, JUNE 18 - 22, 1995, vol. 2, 18 juin 1995 (1995-06-18), pages 663-667, XP000533097 INSTITUTE OF ELECTRICAL AND ELECTRONICS ENGINEERS pragraphe I * figure 3 * --- | 1,14,18 | |
| A | BATTAIL G: "A CONCEPTUAL FRAMEWORK FOR UNDERSTANDING TURBO CODES" IEEE JOURNAL ON SELECTED AREAS IN COMMUNICATIONS, vol. 16, no. 2, février 1998 (1998-02), pages 245-254, XP000741778 pragraphe V * figure 2.3 * * page 250, colonne de gauche, ligne 13 - ligne 30 * paragraphe B (Appendix) intitulé "Decision Rule for Independent Replicas" ----- | 1,14,18 | DOMAINES TECHNIQUES RECHERCHES (Int.Cl.6) |

Le présent rapport a été établi pour toutes les revendications

| Lieu de la recherche | Date d'achèvement de la recherche | Examinateur |
|---|---|---|
| LA HAYE | 20 juillet 1999 | Augarde, E |